(19) Europäisches Patentamt
European Patent Office
Office européen des brevets

(11) **EP 4 790 857 A1**

(12) **EUROPEAN PATENT APPLICATION**
published in accordance with Art. 153(4) EPC


(43) Date of publication:
**12.08.2026 Bulletin 2026/33**

(21) Application number: **24912382.9**

(22) Date of filing: **11.12.2024**

(51) International Patent Classification (IPC):
***H02G 3/14*** $^{(2006.01)}$ ***H01H 45/04*** $^{(2006.01)}$
***H02G 3/16*** $^{(2006.01)}$ ***H05K 7/20*** $^{(2006.01)}$

(52) Cooperative Patent Classification (CPC):
**H01H 45/04; H02G 3/14; H02G 3/16; H05K 7/20**

(86) International application number:
**PCT/JP2024/043851**

(87) International publication number:
**WO 2025/142493 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.12.2023 JP 2023219899**



(71) Applicant: **Sumitomo Riko Company Limited**
**Komaki-shi, Aichi 485-8550 (JP)**

(72) Inventors:
- **MATSUOKA Toshiki**
  **Komaki-shi, Aichi 485-8550 (JP)**
- **SETO Nobuyoshi**
  **Komaki-shi, Aichi 485-8550 (JP)**

(74) Representative: **Becker, Eberhard**
**Becker Kurig & Partner**
**Patentanwälte mbB**
**Bavariastraße 7**
**80336 München (DE)**


(54) **SOUNDPROOF COVER**


(57) The present invention addresses the problem of suppressing noise caused by gaps (C) between a plurality of switching members (91) that are adjacent to each other. This soundproof cover (1) is used in an electrical connection box (9) comprising a base body (90) and a plurality of switching members (91) that are mounted on the base body (90) and disposed spaced apart from each other. The arrangement direction of the base body (90) and the switching members (91) is configured to be the vertical direction in which the base body (90) is on the lower side and the switching members (91) are on the upper side. The soundproof cover (1) comprises: an upper wall part (2) that covers upper surfaces (910) of the plurality of switching members (91); and interposed parts (3) that are interposed in the gaps (C) between the plurality of switching members (91) that are adjacent to each other.

Up
Left
Right
Down
9
1
F
M
911a
V
910
91a
2
3
911b
91b
4
911
91
90
V
C

FIG. 4




Processed by Luminess, 75001 PARIS (FR)

## Description

Technical Field

The present disclosure relates to a soundproof cover for an electrical junction box.

Related Art

In a relay portion of an electrical circuit, in order to perform centralized circuit control, for example, an electrical junction box such as a junction box, a joint box, or a relay box is arranged. On the electrical junction box, for example, an electrical component such as a relay or a fuse is mounted.

Patent Document 1 discloses an electrical junction box in which relay operation noise can be attenuated. A plurality of relays housed in the electrical junction box are each covered by a vibration damping member. A small space is secured between the relay and the vibration damping member to ensure acoustic reflection between these two members. A gap is interposed between two adjacent relays corresponding to the small space.

Prior Art Documents

Patent Documents

Patent Document 1: Japanese Patent Laid-Open No. 2017-200282

SUMMARY OF INVENTION

Technical Problem

As described above, in the case of the electrical junction box of Patent Document 1, a gap is positively and inevitably secured between two adjacent relays. However, as a result of intensive research, the present inventor has obtained a finding that noise may be instead amplified due to the gap. That is, in the gap, resonance may occur due to vibration of gas within the gap, and noise originating from the gap may be generated. In this case, noise may be instead amplified. Accordingly, a soundproof cover of the present disclosure aims to suppress noise caused by a gap between a plurality of switching members adjacent to each other.

Solution to Problem

(1) To solve the above problem, a soundproof cover of the present disclosure is a soundproof cover used in an electrical junction box that includes a base body and a plurality of switching members mounted on the base body and arranged spaced apart from each other. The soundproof cover is characterized in the following. An arrangement direction of the base body and the switching member is defined as an up-down direction with the base body side as a lower side and the switching member side as an upper side. The soundproof cover includes: an upper wall part, covering an upper surface of a plurality of the switching members; and an interposed part, interposed in a gap between a plurality of the switching members adjacent to each other.

The "up-down direction" in the present configuration is defined on the basis of the arrangement direction of the base body and the switching member. The up-down direction is not limited to a direction in which gravity acts. The up-down direction and the direction in which gravity acts may be the same or may differ.

The upper wall part of the soundproof cover of the present configuration covers the upper surface of a plurality of switching members. Hence, noise from the upper surface of a plurality of switching members can be comprehensively suppressed. In the gap between a plurality of switching members adjacent to each other, resonance occurs due to vibration of gas (for example, air) within the gap. In this regard, the interposed part of the soundproof cover of the present configuration is arranged in the gap. That is, the interposed part occupies at least a portion of the gap. Hence, the occurrence of resonance in the gap can be suppressed. Accordingly, noise caused by the gap can be suppressed.

(1-1) In the configuration of (1) above, a configuration is preferable in which a single interposed part is arranged in the gap. According to the present configuration, the number of interposed parts arranged in the gap can be minimized.

(1-2) In the configuration of (1) above, a configuration is preferable in which a plurality of the interposed parts are arranged in the gap. According to the present configuration, a degree of freedom in arrangement (such as number

arranged and arrangement location) of the interposed part in the gap can be increased.

(1-3) In any of the configurations of (1) to (1-2) above, a configuration is preferable in which the upper wall part includes a heat dissipation part having an uneven shape on an upper surface. According to the present configuration, heat dissipation performance of the upper wall part of the soundproof cover can be improved. Rigidity of the upper wall part can be increased.

(1-4) In any of the configurations of (1) to (1-3) above, a configuration is preferable in which at least one of the upper wall part and the interposed part has tackiness with respect to the switching member. According to the present configuration, the upper wall part, or the interposed part, or the upper wall part and the interposed part of the soundproof cover have tackiness with respect to the switching member. Hence, separation of the soundproof cover from the switching member can be suppressed.

(2) In any of the configurations of (1) to (1-4) above, a configuration is preferable in which the interposed part comes into contact with a plurality of the switching members adjacent to each other via the gap. According to the present configuration, heat transfer performance between the interposed part and the switching member can be improved.

(3) In any of the configurations of (1) to (2) above, a configuration is preferable in which the interposed part is integral with the upper wall part, is arranged in a pre-compressed state in the gap, and comes into press-contact with a plurality of the switching members adjacent to each other via the gap. According to the present configuration, the interposed part is press-fitted into the gap. Hence, separation of the interposed part (that is, soundproof cover) from the gap (that is, electrical junction box) can be suppressed.

(4) In any of the configurations of (1) to (3) above, a configuration is preferable in which the upper wall part comes into contact with the upper surface. According to the present configuration, heat transfer performance between the upper wall part and the switching member can be improved.

(5) In any of the configurations of (1) to (4) above, a configuration is preferable in which a direction in which a plurality of the switching members adjacent to each other are aligned is defined as a juxtaposition direction, and a direction substantially orthogonal to the up-down direction and the juxtaposition direction is defined as a first intersecting direction; the interposed part is made of a heat transfer material; the heat transfer material includes a base material and a filler blended in the base material and having a higher thermal conductivity than the base material; and the filler is oriented in at least one direction of the up-down direction and the first intersecting direction. "Substantially orthogonal" in the present configuration means that the first intersecting direction and the up-down direction intersect at an angle within 90 ° (that is, orthogonal) $\pm 5$ °, and also means that the first intersecting direction and the juxtaposition direction intersect at an angle within 90 ° $\pm 5$ °. According to the present configuration, in the interposed part, heat can be transferred along an orientation direction (up-down direction, or first intersecting direction, or up-down direction and first intersecting direction) of the filler. That is, a heat dissipation function can be ensured.

(5-1) In the configuration of (5) above, a configuration is preferable in which the base material is made of foamed resin, and the filler is a magnetic filler. According to the present configuration, a noise suppression function can be ensured by porosity of the base material. During manufacture of the soundproof cover, by foam molding the interposed part in a magnetic field, the magnetic filler can be oriented in a direction of a magnetic line of force, that is, a predetermined direction (at least one direction of up-down direction and first intersecting direction). Hence, a heat dissipation function can be ensured along the orientation direction.

(6) In any of the configurations of (1) to (5-1) above, a configuration is preferable in which a direction intersecting the up-down direction is defined as a second intersecting direction; the upper wall part is made of a heat transfer material; the heat transfer material includes a base material and a filler blended in the base material and having a higher thermal conductivity than the base material; and the filler is oriented in at least one direction of the up-down direction and the second intersecting direction. According to the present configuration, in the upper wall part, heat can be transferred along the orientation direction (up-down direction, or second intersecting direction, or up-down direction and second intersecting direction) of the filler. That is, a heat dissipation function can be ensured.

(6-1) In the configuration of (6) above, a configuration is preferable in which the base material is made of foamed resin, and the filler is a magnetic filler. According to the present configuration, a noise suppression function can be ensured by porosity of the base material. During manufacture of the soundproof cover, by foam molding the upper wall part in a magnetic field, the magnetic filler can be oriented in a direction of a magnetic line of force, that is, a predetermined direction (at least one direction of up-down direction and second intersecting direction). Hence, a heat dissipation function can be ensured along the orientation direction.

(7) In any of the configurations of (1) to (6-1) above, a configuration is preferable in which, among side surfaces of the switching member, a surface facing the gap is defined as an inward facing surface and a surface other than the inward facing surface is defined as an outward facing surface; and the soundproof cover further includes a sidewall part covering the outward facing surface of a plurality of the switching members. According to the present configuration, noise from the outward facing surface of the switching member can be suppressed.

(7-1) In the configuration of (7) above, a configuration is preferable in which the sidewall part comes into contact with the outward facing surface. According to the present configuration, heat transfer performance between the sidewall

part and the switching member can be improved.

(8) In the configuration of (7) or (7-1) above, a configuration is preferable in which a direction intersecting the up-down direction is defined as a second intersecting direction; the sidewall part is made of a heat transfer material; the heat transfer material includes a base material and a filler blended in the base material and having a higher thermal conductivity than the base material; and the filler is oriented in at least one direction of the up-down direction and the second intersecting direction. According to the present configuration, in the sidewall part, heat can be transferred along the orientation direction (up-down direction, or second intersecting direction, or up-down direction and second intersecting direction) of the filler. That is, a heat dissipation function can be ensured.

(8-1) In the configuration of (8) above, a configuration is preferable in which the base material is made of foamed resin, and the filler is a magnetic filler. According to the present configuration, a noise suppression function can be ensured by porosity of the base material. During manufacture of the soundproof cover, by foam molding the sidewall part in a magnetic field, the magnetic filler can be oriented in a direction of a magnetic line of force, that is, a predetermined direction (at least one direction of up-down direction and second intersecting direction). Hence, a heat dissipation function can be ensured along the orientation direction.

(9) To solve the above problem, a soundproof cover of the present disclosure is a soundproof cover used in an electrical junction box that includes a base body and a plurality of switching members mounted on the base body and arranged spaced apart from each other. The soundproof cover is characterized in the following. An arrangement direction of the base body and the switching member is defined as an up-down direction with the base body side as a lower side and the switching member side as an upper side. The soundproof cover includes: an upper wall part, covering an upper surface of a single switching member; and an interposed part, interposed in a gap between a plurality of the switching members adjacent to each other. The interposed part of a plurality of the soundproof covers is arranged in the gap. A plurality of the switching members adjacent to each other via the gap are connected via a plurality of the interposed parts.

The "up-down direction" in the present configuration is defined on the basis of the arrangement direction of the base body and the switching member. The up-down direction is not limited to the direction in which gravity acts. The up-down direction and the direction in which gravity acts may be the same or may differ.

The upper wall part of the soundproof cover of the present configuration covers the upper surface of a single switching member. Hence, noise from the upper surface of a plurality of switching members can be individually suppressed. In the gap between a plurality of switching members adjacent to each other, resonance occurs due to vibration of gas (for example, air) within the gap. In this regard, the interposed part of the soundproof cover of the present configuration is arranged in the gap. That is, the interposed part occupies at least a portion of the gap. Hence, the occurrence of resonance in the gap can be suppressed. Accordingly, noise caused by the gap can be suppressed.

A plurality of switching members adjacent to each other via the gap are connected via a plurality of interposed parts. In other words, a plurality of interposed parts are in contact with a plurality of switching members adjacent to each other via the gap. Hence, heat transfer performance between the interposed part and the switching member can be improved.

(9-1) In the configuration of (9) above, a configuration is preferable in which the upper wall part includes a heat dissipation part having an uneven shape on an upper surface. According to the present configuration, heat dissipation performance of the upper wall part of the soundproof cover can be improved. Rigidity of the upper wall part can be increased.

(9-2) In the configuration of (9) or (9-1) above, a configuration is preferable in which at least one of the upper wall part and the interposed part has tackiness with respect to the switching member. According to the present configuration, the upper wall part, or the interposed part, or the upper wall part and the interposed part of the soundproof cover have tackiness with respect to the switching member. Hence, separation of the soundproof cover from the switching member can be suppressed.

(10) In any of the configurations of (9) to (9-2) above, a configuration is preferable in which the interposed part is integral with the upper wall part; and a plurality of the interposed parts are arranged in a pre-compressed state in the gap and come into press-contact with a plurality of the switching members adjacent to each other via a plurality of the interposed parts. According to the present configuration, a plurality of interposed parts are press-fitted into the gap. Hence, separation of a plurality of interposed parts (that is, a plurality of soundproof covers) from the gap (that is, electrical junction box) can be suppressed.

(11) In any of the configurations of (9) to (10) above, a configuration is preferable in which a direction in which a plurality of the switching members adjacent to each other are aligned is defined as a juxtaposition direction, and a direction substantially orthogonal to the up-down direction and the juxtaposition direction is defined as a first intersecting direction; the interposed part is made of a heat transfer material; the heat transfer material includes a base material and a filler blended in the base material and having a higher thermal conductivity than the base material; and the filler is oriented in at least one direction of the up-down direction and the first intersecting direction. "Substantially orthogonal" in the present configuration means that the first intersecting direction and the up-down direction intersect at an angle within 90 ° (that is, orthogonal) $\pm 5$ °, and also means that the first intersecting direction and the juxtaposition direction intersect at an angle

within 90° ±5°. According to the present configuration, in the interposed part, heat can be transferred along the orientation direction (up-down direction, or first intersecting direction, or up-down direction and first intersecting direction) of the filler. That is, a heat dissipation function can be ensured.

(11-1) In the configuration of (11) above, a configuration is preferable in which the base material is made of foamed resin, and the filler is a magnetic filler. According to the present configuration, a noise suppression function can be ensured by porosity of the base material. During manufacture of the soundproof cover, by foam molding the interposed part in a magnetic field, the magnetic filler can be oriented in a direction of a magnetic line of force, that is, in a predetermined direction (at least one direction of up-down direction and first intersecting direction). Hence, a heat dissipation function can be ensured along the orientation direction.

(12) In any of the configurations of (9) to (11-1) above, a configuration is preferable in which a direction intersecting the up-down direction is defined as a second intersecting direction; the upper wall part is made of a heat transfer material; the heat transfer material includes a base material and a filler blended in the base material and having a higher thermal conductivity than the base material; and the filler is oriented in at least one direction of the up-down direction and the second intersecting direction. According to the present configuration, in the upper wall part, heat can be transferred along the orientation direction (up-down direction, or second intersecting direction, or up-down direction and second intersecting direction) of the filler. That is, a heat dissipation function can be ensured.

(12-1) In the configuration of (12) above, a configuration is preferable in which the base material is made of foamed resin, and the filler is a magnetic filler. According to the present configuration, a noise suppression function can be ensured by porosity of the base material. During manufacture of the soundproof cover, by foam molding the upper wall part in a magnetic field, the magnetic filler can be oriented in a direction of a magnetic line of force, that is, a predetermined direction (at least one direction of up-down direction and second intersecting direction). Hence, a heat dissipation function can be ensured along the orientation direction.

(13) In any of the configurations of (9) to (12-1) above, a configuration is preferable in which, among side surfaces of the switching member, a surface facing the gap is defined as an inward facing surface and a surface other than the inward facing surface is defined as an outward facing surface; and the soundproof cover further includes a sidewall part covering the outward facing surface of the switching member. According to the present configuration, noise generated from the outward facing surface of the switching member can be suppressed.

(14) In the configuration of (13) above, a configuration is preferable in which the sidewall part comes into contact with the outward facing surface. According to the present configuration, heat transfer performance between the sidewall part and the switching member can be improved.

(15) In the configuration of (13) or (14) above, a configuration is preferable in which a direction intersecting the up-down direction is defined as a second intersecting direction; the sidewall part is made of a heat transfer material; the heat transfer material includes a base material and a filler blended in the base material and having a higher thermal conductivity than the base material; and the filler is oriented in at least one direction of the up-down direction and the second intersecting direction. According to the present configuration, in the sidewall part, heat can be transferred along the orientation direction (up-down direction, or second intersecting direction, or up-down direction and second intersecting direction) of the filler. That is, a heat dissipation function can be ensured.

(15-1) In the configuration of (15) above, a configuration is preferable in which the base material is made of foamed resin, and the filler is a magnetic filler. According to the present configuration, a noise suppression function can be ensured by porosity of the base material. During manufacture of the soundproof cover, by foam molding the sidewall part in a magnetic field, the magnetic filler can be oriented in a direction of a magnetic line of force, that is, a predetermined direction (at least one direction of up-down direction and second intersecting direction). Hence, a heat dissipation function can be ensured along the orientation direction.

(16) In any of the configurations above, a configuration is preferable in which, with a volume of the gap as 100%, an occupancy rate of the interposed part with respect to the gap is 7% or more. According to the present configuration, compared to a case where the occupancy rate of the interposed part is less than 7%, noise caused by the gap can be relatively reliably suppressed.

## Effects of Invention

According to the soundproof cover of the present disclosure, noise caused by the gap between a plurality of switching members adjacent to each other can be suppressed.

## BRIEF DESCRIPTION OF THE DRAWINGS

[FIG. 1] FIG. 1 is a perspective view of a junction box including a soundproof cover of a first embodiment.

[FIG. 2] FIG. 2 is an exploded perspective view of the same junction box.
[FIG. 3] FIG. 3 is a cross-sectional view taken along III-III of FIG. 1.
[FIG. 4] FIG. 4 is a cross-sectional view taken along IV-IV of FIG. 3.
[FIG. 5] FIG. 5 is a cross-sectional view taken along V-V of FIG. 4.
[FIG. 6] FIG. 6 is a cross-sectional view in an up-down direction of the same junction box before assembly of the soundproof cover.
[FIG. 7] FIG. 7 is a cross-sectional view in a left-right direction of a junction box of a second embodiment.
[FIG. 8] FIG. 8 is a cross-sectional view in the up-down direction of a junction box of a third embodiment.
[FIG. 9] FIG. 9 is a cross-sectional view in the up-down direction of a junction box of a fourth embodiment.
[FIG. 10] FIG. 10 is a cross-sectional view in the left-right direction of a junction box of a fifth embodiment.
[FIG. 11] FIG. 11 is a perspective view of a junction box of a sixth embodiment.
[FIG. 12] FIG. 12(A) to FIG. 12(E) are partial cross-sectional views in the up-down direction of junction boxes of other embodiments (No. 1 to No. 5).
[FIG. 13] FIG. 13 is a cross-sectional view in the left-right direction of a junction box of another embodiment (No. 6).
[FIG. 14] FIG. 14(A) is a cross-sectional view in the up-down direction of a junction box of Comparative Example 1. FIG. 14(B) is a cross-sectional view in the up-down direction of a junction box of Comparative Example 2.
[FIG. 15] FIG. 15 is a graph showing a test result of a noise suppression test.

## DESCRIPTION OF THE EMBODIMENTS

Hereinafter, embodiments of a soundproof cover of the present disclosure will be described.

### <First Embodiment>

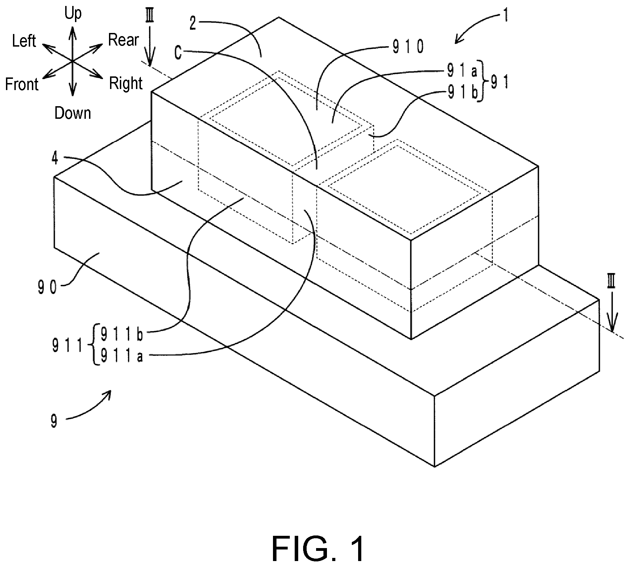

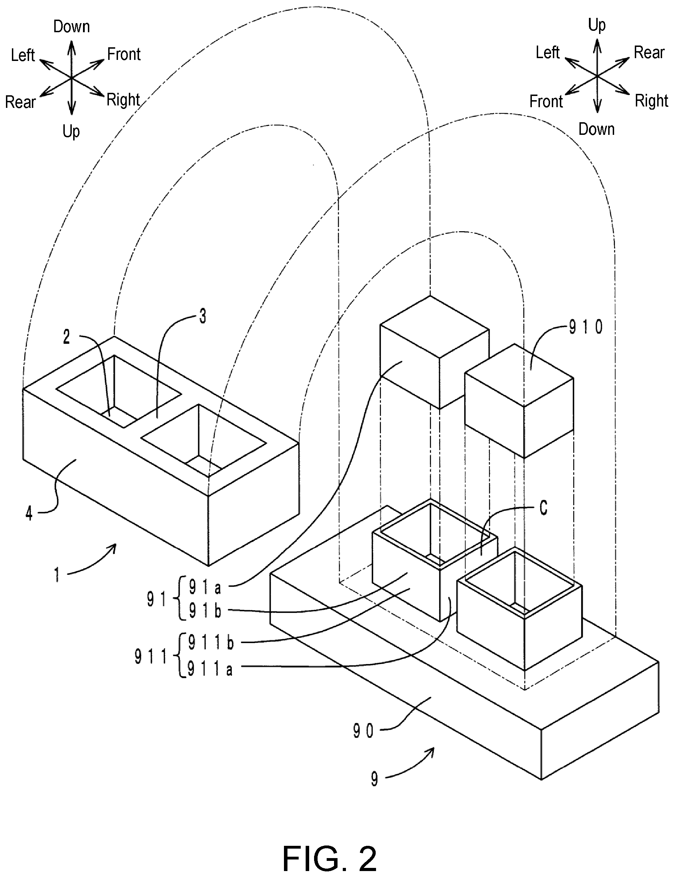

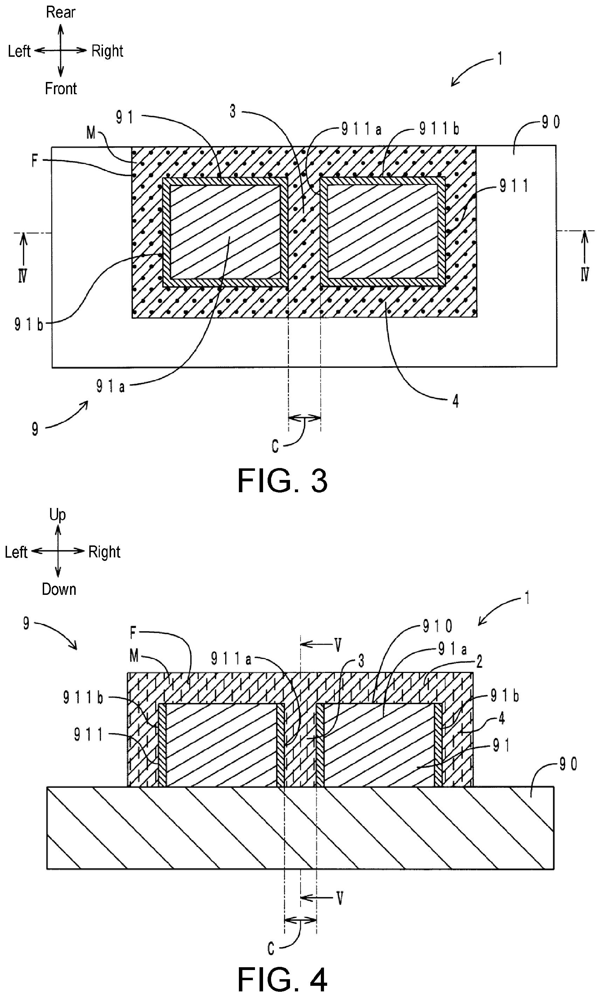

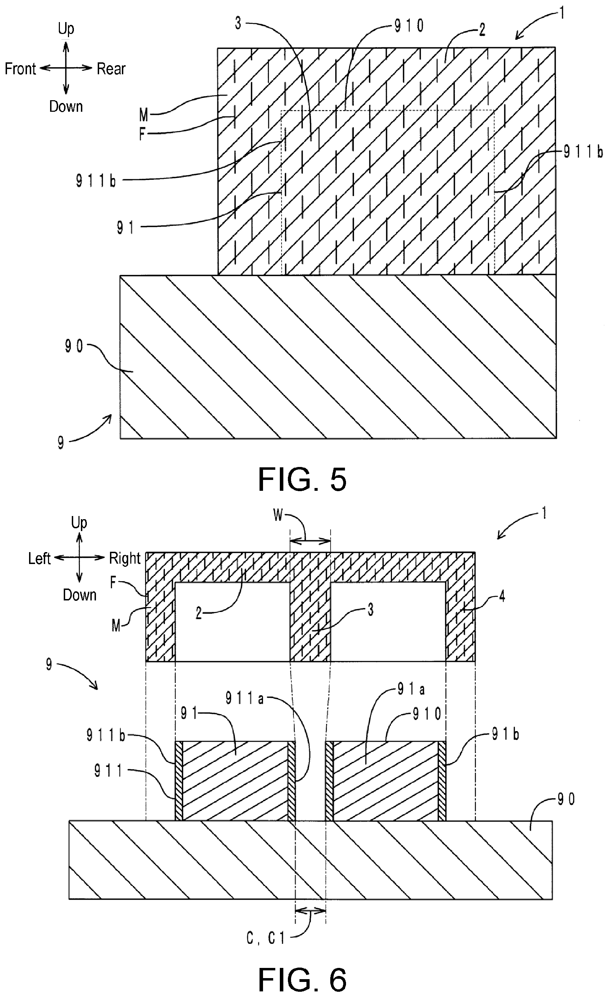

FIG. 1 shows a perspective view of a junction box including a soundproof cover of the present embodiment. FIG. 2 shows an exploded perspective view of the same junction box. FIG. 3 shows a cross-sectional view taken along III-III of FIG. 1. FIG. 4 shows a cross-sectional view taken along IV-IV of FIG. 3. FIG. 5 shows a cross-sectional view taken along V-V of FIG. 4. FIG. 6 shows a cross-sectional view in an up-down direction (cross-sectional view seen from the front side) of the same junction box before assembly of the soundproof cover. In FIG. 3 to FIG. 6, an orientation state of a filler F is schematically shown. That is, the lines "-" and dots "·" in these figures indicate a state in which a plurality of fillers F are connected to each other.

In the present embodiment, an up-down direction (direction in which gravity acts) corresponds to the "up-down direction" of the present disclosure. The up-down direction corresponds to an arrangement direction (lamination direction) of a base body 90 and a relay 91. The base body 90 side is the lower side, and the relay 91 side is the upper side. A left-right direction corresponds to the "juxtaposition direction" of the present disclosure. The left-right direction intersects the up-down direction. A front-rear direction corresponds to the "first intersecting direction" of the present disclosure. The front-rear direction is orthogonal to the left-right direction and the up-down direction. A horizontal direction (front-rear direction, or left-right direction, or a direction intersecting the front-rear direction and the left-right direction) corresponds to the "second intersecting direction" of the present disclosure. The second intersecting direction intersects the up-down direction.

### (Configuration of Junction Box 9)

First, a configuration of a junction box 9 including a soundproof cover 1 of the present embodiment is described. The junction box 9 is included in the concept of the "electrical junction box" of the present disclosure. The junction box 9 is mounted on a vehicle. The junction box 9 controls a charging system, a battery pack, or the like. As shown in FIG. 1 and FIG. 2, the junction box 9 includes the base body 90, a plurality of (two in the present embodiment) relays 91, and the soundproof cover 1. The relay 91 is included in the concept of the "switching member" of the present disclosure.

### (Base Body 90 and Relay 91)

As shown in FIG. 1 and FIG. 2, the base body 90 has a plate shape. The base body 90 is fixed to a body (fixed member; not shown) of the vehicle. The plurality of relays 91 are mounted on an upper surface of the base body 90 together with a plurality of connectors (not shown) or the like. The plurality of relays 91 are arranged spaced apart from each other in the left-right direction. A gap C is secured between the plurality of relays 91. The relay 91 includes a relay body 91a and a frame 91b. The frame 91b has a rectangular frame shape and is erected from the upper surface of the base body 90. The relay body 91a is fixed within the frame of the frame 91b. The relay body 91a is able to control a predetermined circuit to be on (conduction) or off (interruption).

As shown in FIG. 2 to FIG. 6, the relay 91 includes an upper surface 910 and a side surface 911. The upper surface 910 faces upward. The side surface 911 faces the horizontal direction. The side surface 911 includes an inward facing surface 911a and an outward facing surface 911b. The inward facing surface 911a faces the gap C between the plurality of relays 91 described later. The outward facing surface 911b is a surface other than the inward facing surface 911a. The outward facing surface 911b faces outward of a relay group (the plurality of relays 91).

(Soundproof Cover 1)

As shown in FIG. 2 and FIG. 4, the soundproof cover 1 is made of a heat transfer material and has a bottomed box shape opening downward (toward the base body 90). As schematically shown in FIG. 3 to FIG. 6, the heat transfer material forming the soundproof cover 1 includes a base material M and a plurality of fillers (heat dissipation fillers) F. The base material M is a foamed resin (for example, polyurethane foam). The filler F is a magnetic filler (for example, composite particles in which stainless steel particles are composited with graphite particles). The plurality of fillers F are dispersed and blended in the base material M. The filler F has a higher thermal conductivity than the base material M. The heat transfer material has both a noise suppression function and a heat dissipation function.

As shown in FIG. 2 to FIG. 6, the soundproof cover 1 includes an upper wall part 2, an interposed part 3, and a sidewall part 4. The upper wall part 2 covers the upper surface 910 of the plurality of relays 91 from the upper side. The upper wall part 2 is in contact with the upper surface 910. As schematically shown in FIG. 3 to FIG. 6, in the upper wall part 2, the plurality of fillers F are oriented continuously in the up-down direction. The interposed part 3 is arranged in the gap C. The interposed part 3 is integral with the upper wall part 2. As shown in FIG. 6, the interposed part 3 is arranged in the gap C in a pre-compressed state. That is, a thickness W in the left-right direction of the interposed part 3 in a state (natural state; uncompressed state) before being press-fitted into the gap C is larger than the gap C (specifically, a left-right direction length C1 of the gap C). The interposed part 3 is press-fitted into the gap C from the upper side. Hence, the interposed part 3 is in press-contact with a plurality of relays 91 that are adjacent to each other via the gap C due to an elastic restoring force resulting from a compression allowance (= W-C1). In the interposed part 3, the plurality of fillers F are oriented continuously in the up-down direction. The sidewall part 4 covers the outward facing surface 911b of the relay 91 from outside in the horizontal direction. The sidewall part 4 is in contact with the outward facing surface 911b. In the sidewall part 4, the plurality of fillers F are oriented continuously in the up-down direction.

(Effects)

Next, the effects of the soundproof cover 1 of the present embodiment will be described. Noise (operating sound) is generated from the relay 91. If the entire volume of the gap C is a space, since a plurality of relays 91, that is, sound sources, are arranged on both sides in the left-right direction of the gap C, the air in the gap C may vibrate due to mutual interference of sound waves from the plurality of relays 91, and resonance may occur. That is, noise may be generated. In this regard, the interposed part 3 is arranged in the gap C. Hence, the occurrence of resonance in the gap C can be suppressed. Accordingly, noise caused by the gap C can be suppressed.

The upper wall part 2 of the soundproof cover 1 covers the upper surface 910 of the plurality of relays 91. Hence, noise from the upper surface 910 of the plurality of relays 91 can be comprehensively suppressed. A single interposed part 3 is arranged in the gap C. Hence, the number of interposed parts 3 arranged in the gap C can be minimized. The interposed part 3 occupies the entire volume of the gap C. That is, with the volume of the gap C as 100%, an occupancy rate of the interposed part 3 with respect to the gap C is 100%.

The heat transfer material forming the soundproof cover 1 has tackiness due to an unreacted portion of the base material M. Hence, the upper wall part 2, the interposed part 3, and the sidewall part 4 have tackiness with respect to the relay 91. Accordingly, separation of the soundproof cover 1 from the relay 91 can be suppressed.

The interposed part 3 is in contact with a plurality of relays 91 that are adjacent to each other in the left-right direction via the gap C. Hence, heat transfer performance between the interposed part 3 and the relay 91 can be improved. The interposed part 3 is integral with the upper wall part 2, is arranged in a pre-compressed state in the gap C, and is in press-contact with the plurality of relays 91 that are adjacent to each other in the left-right direction via the gap C. Hence, separation of the interposed part 3 (that is, soundproof cover 1) from the gap C (that is, junction box 9) can be suppressed. Due to the elastic restoring force resulting from the compression allowance (= W-C1) shown in FIG. 6, the interposed part 3 is able to suppress vibration of the relay 91. The upper wall part 2 is in contact with the upper surface 910 of the relay 91. Hence, heat transfer performance between the upper wall part 2 and the relay 91 can be improved. The upper wall part 2 is in contact with the upper surface 910 entirely (without gaps). In this regard as well, the heat transfer performance between the upper wall part 2 and the relay 91 can be improved.

The heat transfer material forming the interposed part 3 includes the base material M and the filler F. The filler F has a higher thermal conductivity than the base material M. The filler F is oriented continuously in the up-down direction. Hence, in the interposed part 3, heat can be transferred along the up-down direction. That is, heat can be dissipated from

the interposed part 3 to the outside via the upper wall part 2.

The heat transfer material forming the upper wall part 2 includes the base material M and the filler F. The filler F has a higher thermal conductivity than the base material M. The filler F is oriented continuously in the up-down direction. Hence, in the upper wall part 2, heat can be transferred along the up-down direction. That is, heat can be dissipated from the upper wall part 2 to the outside via an upper surface of the upper wall part 2.

The outward facing surface 911b of the plurality of relays 91 is surrounded and covered by the sidewall part 4 from outside (lateral side) in the horizontal direction. Hence, noise from the outward facing surface 911b of the relay 91 can be suppressed. The sidewall part 4 is in contact with the outward facing surface 911b. Hence, heat transfer performance between the sidewall part 4 and the relay 91 can be improved. The sidewall part 4 is in contact with the outward facing surface 911b entirely (without gaps). In this regard as well, heat transfer performance between the sidewall part 4 and the relay 91 can be improved.

The heat transfer material forming the sidewall part 4 includes the base material M and the filler F. The filler F has a higher thermal conductivity than the base material M. The filler F is oriented continuously in the up-down direction. Hence, in the sidewall part 4, heat can be transferred along the up-down direction. That is, heat can be dissipated from the sidewall part 4 to the outside via the upper wall part 2.

<Second Embodiment>

A difference between a soundproof cover of the present embodiment and the soundproof cover of the first embodiment is that a single relay is covered. That is, a plurality of relays are individually covered by soundproof covers. Here, only the difference is described.

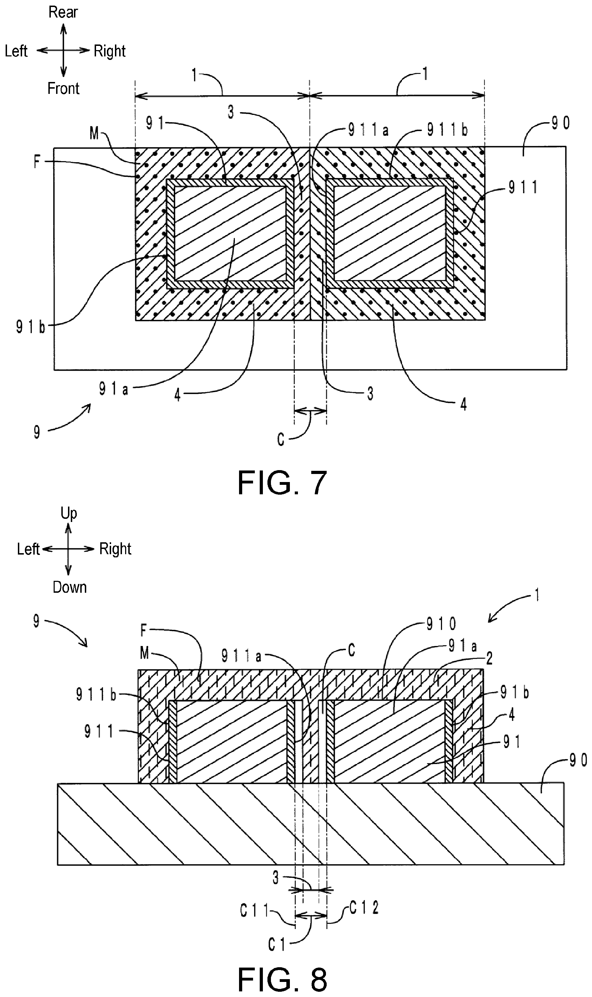

FIG. 7 shows a cross-sectional view in the left-right direction of a junction box of the present embodiment. Portions corresponding to those in FIG. 3 are indicated by the same reference numerals. As shown in FIG. 7, a plurality of relays 91 are each covered by the soundproof cover 1. The number of relays 91 and the number of soundproof covers 1 are the same. In the gap C, the interposed part 3 of a plurality of soundproof covers 1 is arranged. The plurality of relays 91 that are adjacent to each other via the gap C are connected via a plurality of interposed parts 3.

The soundproof cover of the present embodiment and the soundproof cover of the first embodiment have similar effects with respect to portions having common configurations. The upper wall part 2 covers the upper surface 910 (see FIG. 2) of a single relay 91. Hence, noise from the upper surface 910 of the plurality of relays 91 can be individually suppressed for each relay 91. The plurality of interposed parts 3 are arranged in the gap C. Hence, the occurrence of resonance in the gap C can be suppressed. Accordingly, noise caused by the gap C can be suppressed. The plurality of relays 91 that are adjacent to each other in the left-right direction via the gap C are connected via an interposed part group (the plurality of interposed parts 3). In other words, the interposed part group is in contact with the plurality of relays 91 that are adjacent to each other in the left-right direction via the gap C. Hence, the heat transfer performance between the interposed part 3 and the relay 91 can be improved.

<Third Embodiment>

A difference between a soundproof cover of the present embodiment and the soundproof cover of the first embodiment is that an interposed part is arranged only in a portion of a gap. Here, only the difference is described. FIG. 8 shows a cross-sectional view in the up-down direction of the junction box of the present embodiment. Portions corresponding to those in FIG. 4 are indicated by the same reference numerals. As shown in FIG. 8, the interposed part 3 is arranged in a central portion in the left-right direction of the gap C. Specifically, the interposed part 3 is arranged in a section from the 25% position to the 75% position, with the left-right direction length C1 of the gap C as 100%, the left end C11 of the gap C as the 0% position, and a right end C12 as the 100% position. With the volume of the gap C as 100%, the occupancy rate of the interposed part 3 with respect to the gap C is 50%.

The soundproof cover of the present embodiment and the soundproof cover of the first embodiment have similar effects with respect to portions having common configurations. With the volume of the gap C as 100%, the occupancy rate of the interposed part 3 with respect to the gap C is 50%. As in the present embodiment, the interposed part 3 may be arranged only in a portion of the gap C.

<Fourth Embodiment>

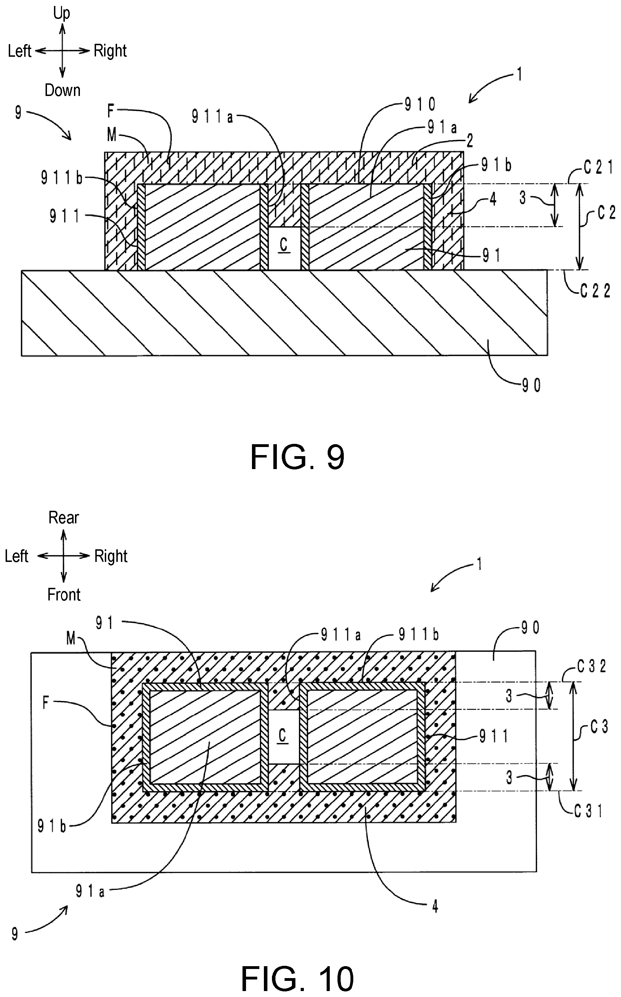

A difference between a soundproof cover of the present embodiment and the soundproof cover of the first embodiment is that an interposed part is arranged only in a portion of a gap. Here, only the difference is described. FIG. 9 shows a cross-sectional view in the up-down direction of a junction box of the present embodiment. Portions corresponding to those in FIG. 4 are indicated by the same reference numerals. As shown in FIG. 9, the interposed part 3 is arranged in an upper portion of the gap C. Specifically, the interposed part 3 is arranged in a section from the 0% position to the 50%

position, with an up-down direction length C2 of the gap C as 100%, an upper end C21 of the gap C as the 0% position, and a lower end C22 as the 100% position. With the volume of the gap C as 100%, the occupancy rate of the interposed part 3 with respect to the gap C is 50%.

The soundproof cover of the present embodiment and the soundproof cover of the first embodiment have similar effects with respect to portions having common configurations. With the volume of the gap C as 100%, the occupancy rate of the interposed part 3 with respect to the gap C is 50%. As in the present embodiment, the interposed part 3 may be arranged only in a portion of the gap C.

In the gap C, heat from a plurality of relays 91 is likely to move upward along with the movement of air. Hence, heat is likely to accumulate in the upper portion of the gap C. In this regard, the interposed part 3 is arranged in the section from the 0% position to the 50% position. Hence, the heat in the upper portion of the gap C can be quickly dissipated to the outside via the interposed part 3 and the upper wall part 2.

<Fifth Embodiment>

A difference between a soundproof cover of the present embodiment and the soundproof cover of the first embodiment is that an interposed part is arranged only in a portion of a gap. Here, only the difference is described. FIG. 10 shows a cross-sectional view in the left-right direction (cross-sectional view seen from above) of a junction box of the present embodiment. Portions corresponding to those in FIG. 3 are indicated by the same reference numerals. As shown in FIG. 10, the interposed part 3 is arranged in a front portion and a rear portion of the gap C. Specifically, the interposed part 3 is arranged in a section from the 0% position to the 25% position and a section from the 75% position to the 100% position, with a front-rear direction length C3 of the gap C as 100%, a front end C31 of the gap C as the 0% position, and a rear end C32 as the 100% position. With the volume of the gap C as 100%, the occupancy rate of the interposed part 3 with respect to the gap C is 50%.

The soundproof cover of the present embodiment and the soundproof cover of the first embodiment have similar effects with respect to portions having common configurations. With the volume of the gap C as 100%, the occupancy rate of the interposed part 3 with respect to the gap C is 50%. As in the present embodiment, the interposed part 3 may be arranged only in a portion of the gap C. A plurality of interposed parts 3 may be arranged with respect to a single gap C. At least two of the arrangement methods of the interposed part 3 shown in the above-described third embodiment (FIG. 8), fourth embodiment (FIG. 9), and fifth embodiment (FIG. 10) may be appropriately combined.

<Sixth Embodiment>

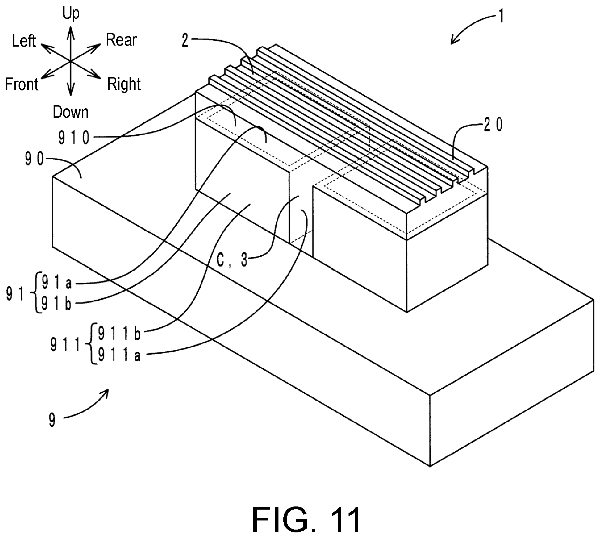

Differences between a soundproof cover of the present embodiment and the soundproof cover of the first embodiment include that an upper wall part includes a heat dissipation part on an upper surface and that no sidewall part is arranged. Here, only the differences are described. FIG. 11 shows a perspective view of a junction box of the present embodiment. Portions corresponding to those in FIG. 1 are indicated by the same reference numerals. As shown in FIG. 11, the soundproof cover 1 includes the upper wall part 2 and the interposed part 3. The soundproof cover 1 does not include the sidewall part 4 (see FIG. 1). Hence, the outward facing surface 911b of the side surface 911 of the relay 91 is exposed to the outside. The upper wall part 2 includes a plurality of heat dissipation parts 20 on an upper surface. The heat dissipation part 20 has a rib shape extending in the left-right direction. The plurality of heat dissipation parts 20 are aligned in the front-rear direction. Due to the plurality of heat dissipation parts 20, the upper surface of the upper wall part 2 has an overall uneven shape.

The soundproof cover of the present embodiment and the soundproof cover of the first embodiment have similar effects with respect to portions having common configurations. According to the present embodiment, compared to a case where the upper surface of the upper wall part 2 has a planar shape, the surface area (heat transfer area) of the upper surface can be increased. Hence, heat dissipation performance can be improved. The rigidity of the upper wall part 2 can be increased. The soundproof cover 1 can be reduced in size since the sidewall part 4 is not arranged.

<Others>

The embodiments of the soundproof cover of the present disclosure have been described above. However, the embodiments are not particularly limited to the above forms. Implementation is also possible in various modified forms and improved forms that can be made by those skilled in the art.

Hereinafter, a type of soundproof cover that collectively covers a plurality of relays 91 as shown in FIG. 1 to FIG. 6 and FIG. 8 to FIG. 11 is appropriately referred to as a "comprehensive type soundproof cover". A type of soundproof cover that individually covers each of a plurality of relays 91 as shown in FIG. 7 is appropriately referred to as an "individual type soundproof cover".

(Regarding Configuration)

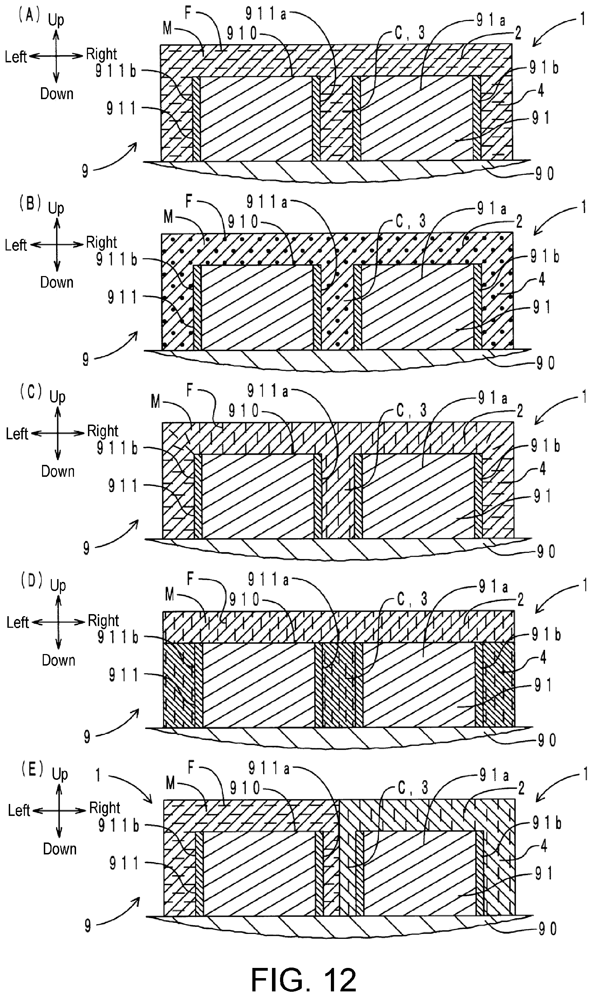

FIG. 12(A) to FIG. 12(E) show partial cross-sectional views in the up-down direction of junction boxes of other embodiments (No. 1 to No. 5). FIG. 12(A) to FIG. 12(D) show a comprehensive type soundproof cover. In FIG. 12(A) to FIG. 12(D), portions corresponding to those in FIG. 4 are indicated by the same reference numerals. FIG. 12(E) shows an individual type soundproof cover. In FIG. 12(E), portions corresponding to those in FIG. 7 are indicated by the same reference numerals.

As shown in FIG. 12(A), in the upper wall part 2, the interposed part 3, and the sidewall part 4, a plurality of fillers F are oriented continuously in the left-right direction. In this manner, in at least one of the upper wall part 2, the interposed part 3, and the sidewall part 4, a plurality of fillers F may be oriented continuously in the left-right direction.

As shown in FIG. 12(B), in the upper wall part 2, the interposed part 3, and the sidewall part 4, a plurality of fillers F are oriented continuously in the front-rear direction. In this manner, in at least one of the upper wall part 2, the interposed part 3, and the sidewall part 4, a plurality of fillers F may be oriented continuously in the front-rear direction.

As shown in FIG. 12(C), in the upper wall part 2 and the sidewall part 4, a plurality of fillers F are oriented continuously in a radial pattern centered on the relay 91. In the interposed part 3, a plurality of fillers F are oriented in the up-down direction. In this manner, in at least one of the upper wall part 2 and the sidewall part 4, a plurality of fillers F may be oriented continuously in a radial pattern. In at least two of the upper wall part 2, the interposed part 3, and the sidewall part 4, a plurality of fillers F may have different orientation directions.

In this manner, the orientation direction of the plurality of fillers F in the upper wall part 2, the interposed part 3, and the sidewall part 4 is not particularly limited. In the interposed part 3, the plurality of fillers F may be oriented in the up-down direction, or the front-rear direction (first intersecting direction), or a direction intersecting the up-down direction and the front-rear direction. In the upper wall part 2 and the sidewall part 4, the plurality of fillers F may be oriented in the up-down direction, or the horizontal direction (second intersecting direction), or a direction intersecting the up-down direction and the horizontal direction.

The plurality of fillers F in at least two of the upper wall part 2, the interposed part 3, and the sidewall part 4 may have the same or different orientation directions. The plurality of fillers F within a single wall part (upper wall part 2, or interposed part 3, or sidewall part 4) may have the same or different orientation directions.

Preferably, it is sufficient that in the interposed part 3, at least one direction end in the orientation direction of the plurality of fillers F is connected to at least one of the upper wall part 2 and the sidewall part 4. In this case, heat can be dissipated to the outside of the soundproof cover 1 from the interposed part 3 via the upper wall part 2, or the sidewall part 4, or the upper wall part 2 and the sidewall part 4.

Preferably, it is sufficient that in the upper wall part 2, at least one direction end in the orientation direction of the plurality of fillers F is open to the outside of the soundproof cover 1. In this case, heat can be dissipated to the outside of the soundproof cover 1 from the upper wall part 2 via an outer surface of the upper wall part 2.

Preferably, it is sufficient that in the sidewall part 4, at least one direction end in the orientation direction of the plurality of fillers F is open to the outside of the soundproof cover 1. In this case, heat can be dissipated to the outside of the soundproof cover 1 from the sidewall part 4 via an outer surface of the sidewall part 4.

As shown in FIG. 12(D), the soundproof cover 1 is a joined body (combined object) of a plurality of members (upper wall part 2, interposed part 3, and sidewall part 4). In this manner, the soundproof cover 1 may be a combined object (FIG. 12(D)) or an integral object (FIG. 12(A) to FIG. 12(C)).

The embodiments of the soundproof cover 1 of the comprehensive type described above using FIG. 12(A) to FIG. 12(D) can be applied not only to the soundproof cover 1 of the comprehensive type but also to the soundproof cover 1 of the individual type (see FIG. 7).

As shown in FIG. 12(E), in the soundproof cover 1 of the individual type on the left side, a plurality of fillers F are oriented continuously in the left-right direction. On the other hand, in the soundproof cover 1 of the individual type on the right side, a plurality of fillers F are oriented continuously in the up-down direction. That is, the plurality of fillers F have different orientation directions between a plurality of soundproof covers 1. In this manner, the plurality of fillers F between the plurality of soundproof covers 1 may have the same or different orientation directions.

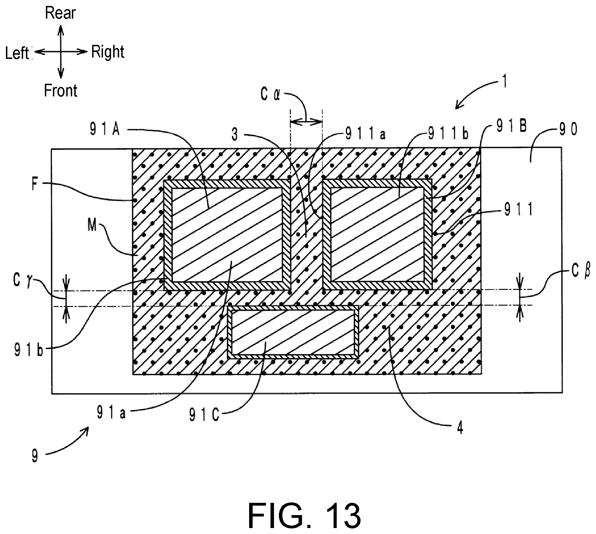

FIG. 13 shows a cross-sectional view in the left-right direction of a junction box of another embodiment (No. 6). Portions corresponding to those in FIG. 3 are indicated by the same reference numerals. As shown in FIG. 13, a plurality of (three in the present embodiment) relays 91A to 91C differ in shape and size. The relays 91A to 91C are included in the concept of "switching member" of the present disclosure. The relay 91A and the relay 91B are aligned in the left-right direction. The relay 91B and the relay 91C are aligned in the front-rear direction (specifically, right rear-left front direction). The relay 91C and the relay 91A are aligned in the front-rear direction (specifically, right front-left rear direction). The interposed part 3 is arranged in a gap $C\alpha$ between the relay 91A and the relay 91B, a gap $C\beta$ between the relay 91B and the relay 91C, and a gap $C\gamma$ between the relay 91C and the relay 91A.

In this manner, the shape, size, position, number arranged, juxtaposition direction, and the like of the plurality of relays 91A to 91C are not particularly limited. The plurality of relays 91A to 91C may be the same or different in shape and

size. The juxtaposition direction of the plurality of relays 91A to 91C may be, for example, the left-right direction, or the front-rear direction, or a direction intersecting the left-right direction and the front-rear direction. The shape, size, position, number arranged, and the like of the interposed part 3 are not particularly limited. It is sufficient that the interposed part 3 is arranged in at least one of the gaps $C\alpha$ to $C\gamma$.

The first intersecting direction may be a direction intersecting the above-described juxtaposition direction at an angle within 90 °±5 ° (that is, 85 ° or more to 95 ° or less). The first intersecting direction may be a direction intersecting the up-down direction at an angle within 90 °±5 °.

The second intersecting direction may be any direction intersecting the up-down direction. That is, the second intersecting direction may be any direction other than the up-down direction. The second intersecting direction may be a direction orthogonal to the up-down direction or a direction not orthogonal to the up-down direction. The second intersecting direction may be, for example, the left-right direction, or the front-rear direction, or a direction intersecting the left-right direction and the front-rear direction.

The up-down direction corresponds to an arrangement direction (lamination direction) of the base body 90 and the relays 91 and 91A to 91C. The up-down direction is not limited to the direction in which gravity acts. The up-down direction and the direction in which gravity acts may be the same or different. For example, the up-down direction may be the direction in which gravity acts, or a horizontal direction orthogonal to the direction in which gravity acts, or a direction intersecting the direction in which gravity acts and the horizontal direction.

The configuration and number of members of the relay 91 are not particularly limited. The relay 91 may not include the frame 91b. It is sufficient that the relay 91 is fixed to a predetermined position in the base body 90 by a positioning member (for example, frame 91b, a bolt, a screw, or an engagement claw). The relay 91 may be composed only of the relay body 91a.

In FIG. 11, the heat dissipation part 20 having a rib shape is arranged on the upper surface of the upper wall part 2. The extension direction of the heat dissipation part 20 and the number thereof arranged are not particularly limited. The heat dissipation part 20 may extend in the front-rear direction. The heat dissipation part 20 may extend in a direction intersecting the left-right direction and the front-rear direction. The heat dissipation part 20 may not have a rib shape. For example, the heat dissipation part 20 having an embossed shape, groove shape, dimple shape or the like may be arranged on the upper surface of the upper wall part 2. It is sufficient that the upper surface exhibits an uneven shape. The above-described heat dissipation part 20 may be arranged on at least one of the outer surface of the upper wall part 2 and the outer surface of the sidewall part 4 of the soundproof cover 1 shown in FIG. 2.

The switching member is not limited to the relay 91. The switching member may be any member having a function capable of switching an AC power supply. The electrical junction box is not limited to the junction box 9. For example, the electrical junction box may be an electronic control system component having a switching member, such as a joint box, a relay box, a converter, an inverter, or an electronic control unit (ECU).

The soundproof cover 1 may be interposed between the base body 90 and the relay 91. In this manner, noise (specifically, noise in a frequency band of 630 kHz or more to 2000 kHz or less) from the relay 91 can be suppressed. In particular, in the case where a magnetic induction foaming (MIF, which is a registered trademark of Sumitomo Riko Company Limited) material is used as a material of the soundproof cover 1, a relatively good noise suppression effect can be achieved in a frequency band of 2000 Hz or less. It is presumed that the noise suppression effect can be achieved due to the fact that solid-borne sound generated from the junction box 9 is reduced by a vibration damping action of the soundproof cover 1 made of the MIF material.

(Regarding Materials)

A material of the heat transfer material forming at least one of the upper wall part 2, the interposed part 3, and the sidewall part 4 is not particularly limited. The heat transfer material may or may not contain the filler F. As the base material M, for example, a polymer can be used. It is sufficient that the type of polymer is appropriately determined in consideration of the noise suppression function and the heat dissipation function. The polymer may be a solid body or a porous body. Examples of the solid body include: crosslinked rubber, such as urethane rubber, silicone rubber, fluorine rubber, acrylic rubber, and acrylonitrile butadiene rubber; and a thermoplastic elastomer, such as styrene-based elastomer, olefin-based elastomer, vinyl chloride-based elastomer, polyester-based elastomer, polyurethane-based elastomer, and polyamide-based elastomer. Examples of the porous body include foamed resin such as polyurethane foam, polyethylene foam, and polypropylene foam. From the viewpoint of ensuring a high noise suppression function, the polymer is preferably foamed resin.

It is sufficient that the filler F has orientation. For example, orientation may be provided by a plurality of fillers F being connected in a predetermined direction. The filler F itself may have shape anisotropy. Examples of a magnetic filler forming the filler F include: a ferromagnetic body, such as iron, nickel, cobalt, gadolinium, and stainless steel; an antiferromagnetic body, such as MnO, $Cr_2O_3$, $FeCl_2$, and MnAs; and alloys using the same. Among them, stainless steel, a copper-iron alloy and the like are preferable from the viewpoint of high thermal conductivity and excellent

processability as a magnetic filler. From the viewpoint of improving heat dissipation, composite particles in which magnetic particles are attached to a surface of thermally conductive particles having high thermal conductivity may be used as the magnetic filler. As a material of the thermally conductive particles, for example, a carbon material, such as graphite, expanded graphite, or carbon fiber is preferable.

A method for imparting tackiness to the heat transfer material is not particularly limited. For example, an adhesive may be added to the heat transfer material. Tackiness may be imparted by the unreacted portion of the base material M. Tackiness may be imparted by increasing the surface roughness of a desired wall part among the upper wall part 2, the interposed part 3, and the sidewall part 4. The heat transfer material forming at least two of the upper wall part 2, the interposed part 3, and the sidewall part 4 may be the same or different.

A manufacturing method of the soundproof cover 1 is not particularly limited. As an example, the manufacturing method of the soundproof cover 1 includes a raw material preparation process and a foam molding process. In the raw material preparation process, a raw material is prepared in which a foamed urethane resin raw material, a filler (magnetic filler), a foaming agent, a catalyst, or the like are mixed together. In the foam molding process, the raw material is injected into a cavity of a molding die, and is foam molded into a predetermined shape while a magnetic field is applied thereto. That is, the filler is oriented in a predetermined direction (direction of a magnetic line of force). In this manner, the soundproof cover 1 may be manufactured.

## Examples

Next, a noise suppression test (test 1 and test 2) conducted on the soundproof cover of the present disclosure will be described.

### [Test 1]

<Sample>

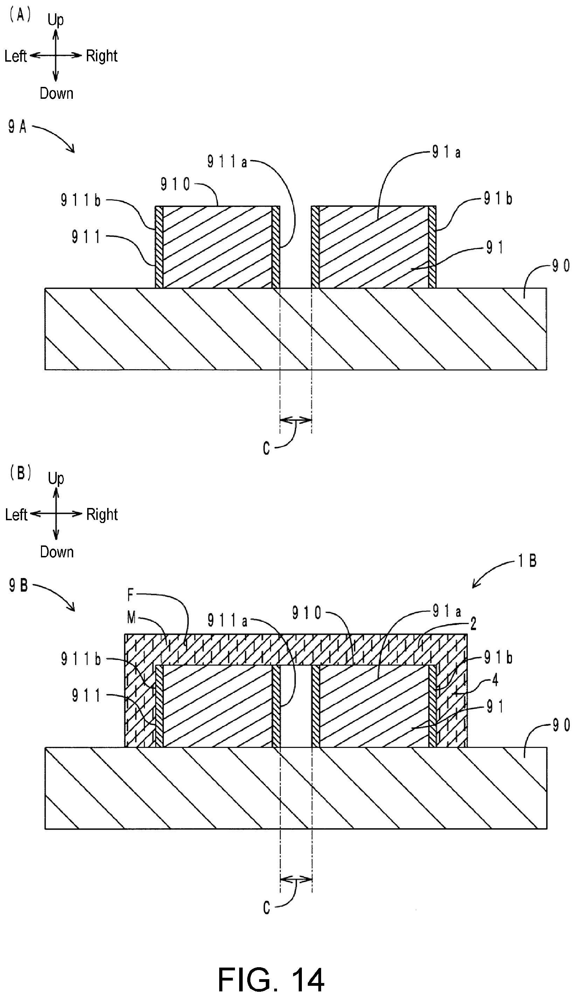

First, a configuration of a sample (Example 1, Comparative Example 1, and Comparative Example 2) used in test 1 will be described. FIG. 14(A) shows a cross-sectional view in the up-down direction of a junction box of Comparative Example 1, and FIG. 14(B) shows a cross-sectional view in the up-down direction of a junction box of Comparative Example 2. Portions corresponding to those in FIG. 4 are indicated by the same reference numerals.

Example 1 included the junction box 9 including the soundproof cover 1 of the first embodiment shown in FIG. 1 to FIG. 6. Comparative Example included a junction box 9A shown in FIG. 14(A). Comparative Example 1 included no soundproof cover. Comparative Example 2 included a junction box 9B shown in FIG. 14(B). Comparative Example 2 included a soundproof cover 1B. However, the soundproof cover 1B included no interposed part (interposed part 3 shown in FIG. 4). Hence, the entire volume of the gap C was occupied by air.

<Test Method>

Next, a test method will be described. In the test, noise of predetermined frequencies (5 kHz, 10 kHz, and 15 kHz) was generated from the relay 91 of each sample. The noise was generated by supplying current to the relay 91 from a bipolar power supply (switching power supply) at a predetermined driving frequency and actually operating the relay 91. Switching of the frequency was performed by switching the driving frequency of the bipolar power supply.

For each sample and for each frequency, a sound power level at a predetermined measurement position was collected using a sound collection microphone. The predetermined measurement position was a position 40 cm above the sample (specifically, above the center of gravity of the gap C having a rectangular shape when the sample is viewed from above).

<Test Result>

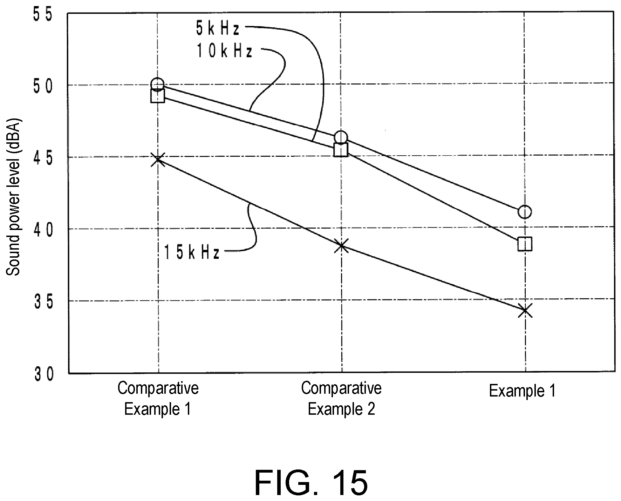

Next, a test result will be described. FIG. 15 shows a test result of the noise suppression test in a graph. Regarding the correspondence between symbols and frequencies, a square (□) indicates data at a frequency of 5 kHz, a circle (◦) indicates data at a frequency of 10 kHz, and a cross (×) indicates data at a frequency of 15 kHz.

Regarding how to read FIG. 15, the lower the sound power level on the vertical axis, the quieter the vicinity of the sound collection microphone, meaning that noise from the relay 91 is suppressed. As shown in FIG. 15, at all frequencies, Example 1 had the lowest sound power level, Comparative Example 2 had the second lowest sound power level, and Comparative Example 1 had the highest sound power level. From this, it is understood that Example 1 had the highest noise suppression performance, Comparative Example 2 had the second highest noise suppression performance, and Comparative Example 1 had the lowest noise suppression performance. In this manner, compared to Comparative

Example 1 and Comparative Example 2, Example 1 is able to exhibit high noise suppression performance in a frequency band of 5 kHz or more to 15 kHz or less.

[Test 2]

<Sample>

In Test 2, Example 1 and Comparative Example 2 from Test 1 described above, and newly added Examples 2 to 5 were used. Examples 2 to 5 included the junction box 9 including the soundproof cover 1 of the fourth embodiment shown in FIG. 9. In the case of the soundproof cover 1 shown in FIG. 9, the occupancy rate (hereinafter abbreviated as "occupancy rate" as appropriate) of the interposed part 3 with respect to the gap C when the volume of the gap C is 100% is 50%. In contrast, the occupancy rate of Example 1 (FIG. 1 to FIG. 6) was 100%, the occupancy rate of Example 2 was 65%, the occupancy rate of Example 3 was 44%, the occupancy rate of Example 4 was 22%, the occupancy rate of Example 5 was 7%, and the occupancy rate of Comparative Example 2 (FIG. 14(B)) was 0%.

<Test Method>

In the test, noise at a predetermined frequency (10 kHz) was generated from the relay 91 of each sample. Other conditions are the same as those in Test 1 described above.

<Test Result>

Table 1 shows a test result of the noise suppression test.

[Table 1]

| | Example 1 | Example 2 | Example 3 | Example 4 | Example 5 | Comparative Example 2 |
|---|---|---|---|---|---|---|
| Occupancy rate (%) of interposed part | 100 | 65 | 44 | 22 | 7 | 0 |
| Sound power reduction effect | 1 | 0.87 | 0.61 | 0.28 | 0.15 | 0 |

Regarding the "sound power reduction effect" in the table, the value of Example 1 (occupancy rate = 100%) was set to 1, and the value of Comparative Example 2 (occupancy rate = 0%) was set to 0. The values of Examples 2 to 5 are relative values to these values.

The sound power reduction effect is calculated from the following expression. In the expression, "sound power level of each sample" refers to the sound power level of any of Examples 2 to 5. The unit of sound power level is "dBA."

Sound power reduction effect = {(sound power level of Comparative Example 2) - (sound power level of each sample)} / {(sound power level of Comparative Example 2) - (sound power level of Example 1)}

As shown in Table 1, in order of higher sound power reduction effect, the following result is obtained: Example 1 (occupancy rate = 100%), Example 2 (occupancy rate = 65%), Example 3 (occupancy rate = 44%), Example 4 (occupancy rate = 22%), Example 5 (occupancy rate = 7%), and Comparative Example 2 (occupancy rate = 0%). From this, it is understood that the higher the occupancy rate of the interposed part 3 with respect to the gap C, the higher the sound power reduction effect. It is understood that if the occupancy rate is 7% or more, the sound power reduction effect, that is, the noise suppression performance, can be reliably exhibited compared to the case where the occupancy rate is 0%.

Description of Reference Numerals

1: soundproof cover; 1B: soundproof cover; 2: upper wall part; 20: heat dissipation part; 3: interposed part; 4: sidewall part; 9: junction box (electrical junction box); 9A: junction box; 9B: junction box; 90: base body; 91: relay (switching member); 91A to 91C: relay (switching member); 91a: relay body; 91b: frame; 910: upper surface; 911: side surface; 911a: inward facing surface; 911b: outward facing surface; C: gap; $C\alpha$ to $C\gamma$: gap; C1: left-right direction length; C11: left end; C12: right end; C2: up-down direction length; C21: upper end; C22: lower end; C3: front-rear direction length; C31: front end; C32: rear end; F: filler; M: base material; W: thickness

## Claims

1. A soundproof cover, used in an electrical junction box that comprises a base body and a plurality of switching members mounted on the base body and arranged spaced apart from each other, **characterized in that**,

   an arrangement direction of the base body and the switching member is defined as an up-down direction with the base body side as a lower side and the switching member side as an upper side; and
   the soundproof cover comprises:

   an upper wall part, covering an upper surface of a plurality of the switching members; and
   an interposed part, interposed in a gap between a plurality of the switching members adjacent to each other.

2. The soundproof cover according to claim 1, wherein the interposed part comes into contact with a plurality of the switching members adjacent to each other via the gap.

3. The soundproof cover according to claim 2, wherein the interposed part is integral with the upper wall part, is arranged in a pre-compressed state in the gap, and comes into press-contact with a plurality of the switching members adjacent to each other via the gap.

4. The soundproof cover according to claim 1, wherein the upper wall part comes into contact with the upper surface.

5. The soundproof cover according to claim 1, wherein

   a direction in which a plurality of the switching members adjacent to each other are aligned is defined as a juxtaposition direction, and a direction substantially orthogonal to the up-down direction and the juxtaposition direction is defined as a first intersecting direction;
   the interposed part is made of a heat transfer material;
   the heat transfer material comprises a base material and a filler blended in the base material and having a higher thermal conductivity than the base material; and
   the filler is oriented in at least one direction of the up-down direction and the first intersecting direction.

6. The soundproof cover according to claim 1, wherein

   a direction intersecting the up-down direction is defined as a second intersecting direction;
   the upper wall part is made of a heat transfer material;
   the heat transfer material comprises a base material and a filler blended in the base material and having a higher thermal conductivity than the base material; and
   the filler is oriented in at least one direction of the up-down direction and the second intersecting direction.

7. The soundproof cover according to claim 1, wherein

   among side surfaces of the switching member, a surface facing the gap is defined as an inward facing surface and a surface other than the inward facing surface is defined as an outward facing surface; and
   the soundproof cover further comprises a sidewall part covering the outward facing surface of a plurality of the switching members.

8. The soundproof cover according to claim 7, wherein

   a direction intersecting the up-down direction is defined as a second intersecting direction;
   the sidewall part is made of a heat transfer material;
   the heat transfer material comprises a base material and a filler blended in the base material and having a higher thermal conductivity than the base material; and
   the filler is oriented in at least one direction of the up-down direction and the second intersecting direction.

9. A soundproof cover, used in an electrical junction box that comprises a base body and a plurality of switching members mounted on the base body and arranged spaced apart from each other, **characterized in that**,

   an arrangement direction of the base body and the switching member is defined as an up-down direction with the

base body side as a lower side and the switching member side as an upper side;
the soundproof cover comprises:

an upper wall part, covering an upper surface of a single switching member; and
an interposed part, interposed in a gap between a plurality of the switching members adjacent to each other;

the interposed part of a plurality of the soundproof covers is arranged in the gap; and
a plurality of the switching members adjacent to each other via the gap are connected via a plurality of the interposed parts.

**10.** The soundproof cover according to claim 9, wherein

the interposed part is integral with the upper wall part; and
a plurality of the interposed parts are arranged in a pre-compressed state in the gap and come into press-contact with a plurality of the switching members adjacent to each other via a plurality of the interposed parts.

**11.** The soundproof cover according to claim 9, wherein

a direction in which a plurality of the switching members adjacent to each other are aligned is defined as a juxtaposition direction, and a direction substantially orthogonal to the up-down direction and the juxtaposition direction is defined as a first intersecting direction;
the interposed part is made of a heat transfer material;
the heat transfer material comprises a base material and a filler blended in the base material and having a higher thermal conductivity than the base material; and
the filler is oriented in at least one direction of the up-down direction and the first intersecting direction.

**12.** The soundproof cover according to claim 9, wherein

a direction intersecting the up-down direction is defined as a second intersecting direction;
the upper wall part is made of a heat transfer material;
the heat transfer material comprises a base material and a filler blended in the base material and having a higher thermal conductivity than the base material; and
the filler is oriented in at least one direction of the up-down direction and the second intersecting direction.

**13.** The soundproof cover according to claim 1 or claim 9, wherein with a volume of the gap as 100%, an occupancy rate of the interposed part with respect to the gap is 7% or more.

Up
Left
Rear
Front
Right
Down
Ⅲ
2
C
1
910
91a
91b
91
4
90
911
911b
911a
9
Ⅲ

FIG. 1

Down
Left
Front
Rear
Right
Up
Up
Left
Rear
Front
Right
Down
2
3
4
1
910
C
91
91a
91b
911
911b
911a
90
9

FIG. 2

Rear
Left
Right
Front
1
91
3
911a
911b
90
M
F
911
IV
IV
91b
91a
4
9
C

FIG. 3

Up
Left
Right
Down
1
9
F
910
V
M
911a
91a
3
2
911b
91b
4
911
91
90
V
C

FIG. 4

Up
Front
Rear
Down
3
910
2
1
M
F
911b
911b
91
90
9

FIG. 5

Up
Left
Right
Down
W
1
F
2
3
4
M
9
911a
91a
91
910
911b
91b
911
90
C, C1

FIG. 6

Rear
Left
Right
Front
1
1
3
9 1
9 1 1 a
9 1 1 b
9 0
M
F
9 1 1
9 1 b
9 1 a
4
3
4
9
C

FIG. 7

Up
Left
Right
Down
1
9
F
9 1 0
M
9 1 1 a
C
9 1 a
2
9 1 1 b
9 1 b
4
9 1 1
9 1
9 0
3
C 1 1
C 1 2
C 1

FIG. 8

Up
Left
Right
Down
1
9
F
M
911a
910
91a
2
91b
911b
C21
3
4
C2
911
C
91
C22
90

FIG. 9

Rear
Left
Right
Front
1
91
M
911a
911b
90
C32
F
3
C
C3
911
3
91b
C31
91a
4
9

FIG. 10

Up
Left
Rear
Front
Right
Down
2
1
910
20
90
C, 3
91
91a
91b
911
911b
911a
9

FIG. 11

(A)
(B)
(C)
(D)
(E)
Up
Down
Left
Right
F
M
910
911a
911b
911
91a
91b
91
90
C, 3
1
2
4
9

FIG. 12

Rear
Left
Right
Front
1
C α
91A
3
911a
911b
91B
90
F
911
M
C γ
C β
91b
91a
91C
4
9

FIG. 13

(A)
Up
Left
Right
Down
9A
911a
910
91a
911b
91b
911
91
90
C
(B)
Up
Left
Right
Down
1B
9B
F
M
911a
910
91a
2
911b
91b
4
911
91
90
C

FIG. 14

55
50
45
40
35
30
Sound power level (dBA)
5kHz
10kHz
15kHz
Comparative Example 1
Comparative Example 2
Example 1

FIG. 15

## INTERNATIONAL SEARCH REPORT

International application No. **PCT/JP2024/043851**

**A. CLASSIFICATION OF SUBJECT MATTER**

***H02G 3/14***(2006.01)i; ***H01H 45/04***(2006.01)i; ***H02G 3/16***(2006.01)i; ***H05K 7/20***(2006.01)i
FI: H02G3/14; H01H45/04; H02G3/16; H05K7/20 F

According to International Patent Classification (IPC) or to both national classification and IPC

**B. FIELDS SEARCHED**

Minimum documentation searched (classification system followed by classification symbols)

H02G3/14; H01H45/04; H02G3/16; H05K7/20

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2017-200282 A (SUMITOMO WIRING SYSTEMS, LTD.) 02 November 2017 (2017-11-02) paragraphs [0017]-[0045], fig. 1-4 | 1-4, 7, 9-10, 13 |
| A | | 5-6, 8, 11-12 |
| A | JP 2005-304162 A (AUTONETWORKS TECHNOLOGIES, LTD.) 27 October 2005 (2005-10-27) entire text, all drawings | 1-13 |
| A | JP 2016-092170 A (HONDA MOTOR CO., LTD.) 23 May 2016 (2016-05-23) entire text, all drawings | 1-13 |

☐ Further documents are listed in the continuation of Box C.

☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **09 January 2025** | **21 January 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/043851**

| Patent document cited in search report | Publication date (day/month/year) | Patent family member(s) | Publication date (day/month/year) |
|---|---|---|---|
| JP 2017-200282 A | 02 November 2017 | (Family: none) | |
| JP 2005-304162 A | 27 October 2005 | (Family: none) | |
| JP 2016-092170 A | 23 May 2016 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017200282 A